# EUROPÄISCHE PATENTSCHRIFT

(11) **EP 3 268 755 B1**
(45) Veröffentlichungstag und Bekanntmachung des Hinweises auf die Patenterteilung: **31.03.2021**
(21) Anmeldenummer: 16702707.7
(22) Anmeldetag: 02.02.2016
(51) Int. Cl.: G01R 22/06, G01D 4/00, G05B 15/02, G06Q 50/06, H04L 12/28

(54) **SYSTEM ZUR ERMITTLUNG DES ENERGIEVERBRAUCHS EINES EINZELNEN VERBRAUCHERS**
SYSTEM FOR DETERMINING THE ENERGY CONSUMPTION OF AN INDIVIDUAL CONSUMER
SYSTÈME SERVANT À DÉTERMINER LA CONSOMMATION INDIVIDUELLE D'ÉNERGIE D'UN CONSOMMATEUR

(30) Priorität: 13.03.2015 DE 102015103682
(43) Veröffentlichungstag der Anmeldung: 17.01.2018
(73) Patentinhaber: ABB AG, 68309 Mannheim (DE)
(72) Erfinder: KRUSE, Jörn, 68239 Mannheim (DE); VOGEL, Stefan, 69502 Hemsbach (DE)
(86) Internationale Anmeldenummer: PCT/EP2016/052149
(87) Internationale Veröffentlichungsnummer: WO 2016/146298

(56) Entgegenhaltungen:
- EP-A1- 1 936 454
- WO-A1-2009/010892
- WO-A1-2014/110109
- DE-A1-102012 108 536

## Beschreibung

Die Erfindung betrifft ein System zur Ermittlung des Energieverbrauchs eines einzelnen Verbrauchers, der an ein Stromnetz in einem Gebäude angeschlossen ist.

Verfahren zur Bestimmung des Energieverbrauchs sind beispielsweiser aus der DE 102012108536 A1, WO 2014/110109 A1, EP 1936454 A1 und WO 2009/010892 A1 bekannt.

An ein Stromnetz in einem Gebäude, beispielsweis einen Wohngebäude oder einem Zweckbau, wie einem Hotel, einem Bürogebäude oder einer Fertigungshalle, sind üblicherweise eine Vielzahl von Verbrauchern oder einzelnen Lastkreisen, die jeder für sich wieder eine Vielzahl von Verbrauchern hat, angeschlossen, Verbraucher sind typischerweise Beleuchtungsvorrichtungen, Lampen jeder Art mit oder ohne Dimmer, Antriebe für Jalousien, Haushaltsgeräte wie Kühlschrank, Waschmaschine, trockner, Klimageräte oder Klimaanlagen, Heizungsanlagen, Einbruchsmeldeanlagen und dergleichen.

Mit steigenden Energiekosten, knapper werdenden Ressourcen und neuen Technologien zum Gebäudemanagement und zur Energieübertragung und -Verteilung, wie beispielsweise von als Demand Site Management bekannt gewordenen Konzepten oder der Einführung von Smart Grids steigt die Notwendigkeit einer Verbrauchs- bzw. Energieerfassung und der Bedarf an Echtzeitinformationen von elektrischen Verbrauchern und Lasten. Unter Smart Grid, zu deutsch "intelligentes Netz", versteht man dabei die kommunikative Vernetzung und Steuerung von Stromerzeugern, Speichern, elektrischen Verbrauchern und Netzbetriebsmitteln in Energieübertragungs- und -verteilungsnetzen der Elektrizitätsversorgung. Diese ermöglichen eine Optimierung und Überwachung der miteinander verbundenen Bestandteile, wobei das Ziel die Sicherstellung der Energieversorgung auf Basis eines effizienten und zuverlässigen Systembetriebs ist.

Dabei wird es vermehrt notwendig, den Energieverbrauch einzelner Lasten oder Stromkreise zu erfassen.

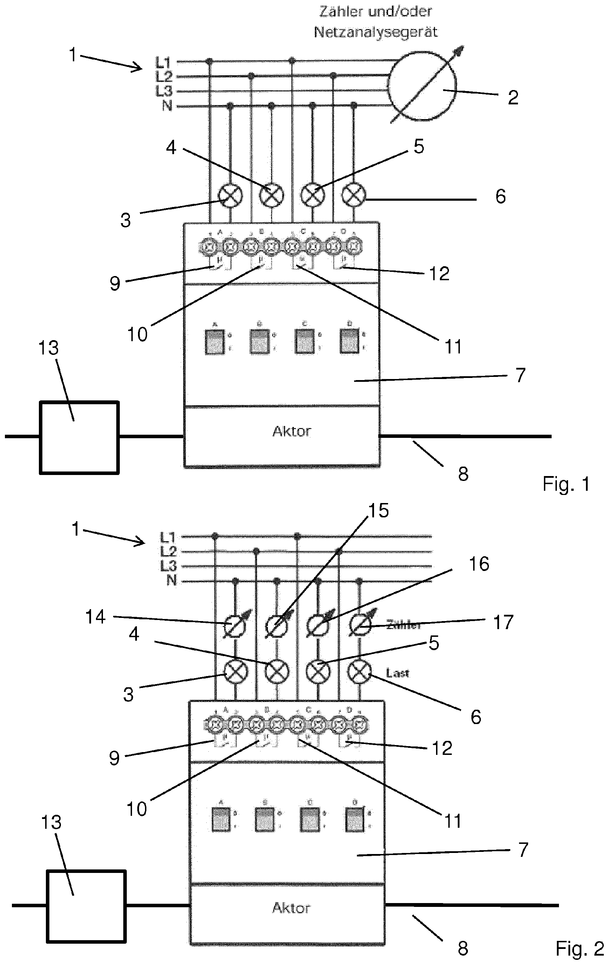

Derzeit wird der elektrische Energieverbrauch eines Gebäudes allerdings nur gesamthaft, als Summenverbrauch, für alle Verbraucher bzw. Lastkreise in einem Gebäude erfasst, über einen zentralen Zähler, der vor der Unterverteilung zu den einzelnen Laststromkreisen bzw. Lasten angebracht ist, siehe Figur 1.

Eine separate Erfassung des Verbrauchs einzelner Verbraucher oder Lastkreise ist heute nur möglich, indem jedem Verbraucher oder Lastkreis ein einzelner Zähler zugeordnet ist, siehe Figur 2. Dies ist, insbesondere in größeren Gebäuden mit einer Vielzahl an Verbrauchern oder Lastkreisen, sehr aufwändig, da eine Vielzahl von Zählern eingesetzt und installiert werden müssen.

Es ist daher die der vorliegenden Erfindung zugrunde liegende Aufgabe, ein System zur Ermittlung des Energieverbrauchs eines einzelnen Verbrauchers, der an ein Stromnetz in einem Gebäude angeschlossen ist, zu schaffen, das keinen erhöhten Installationsaufwand erfordert. Die Ermittlung des Energieverbrauchs eines einzelnen Verbrauchers wird hier und im Folgenden auch als Einzellasterkennung bezeichnet. Die der Erfindung zugrundeliegende Aufgabe wird erfindungsgemäß gelöst durch ein System gemäß Anspruch 1.

Erfindungsgemäß erfolgt die Einzellasterkennung über bzw. unter Verwendung eines busbasierten Gebäudeautomatisierungssystems.

Ein busbasiertes Gebäudeautomatisierungssystem zeichnet sich dadurch aus, dass es keine zentrale Steuereinheit wie etwa eine zentrale SPS gibt, mit der die Sensoren und Aktoren des Gebäudeautomatisierungssystems sternförmig verbunden wären. In einem busbasierten Gebäudeautomatisierungssystem, wie es hier gemeint ist, sind alle Sensoren und Aktoren im Gebäude mittels einer Busleitung ringförmig verbunden und mit der Fähigkeit ausgestattet, untereinander Informationen auszutauschen. Ein bekanntes und oft eingesetztes Bussystem der Gebäudeautomatisierungstechnik ist das KNX-Bussystem, siehe www.knx.de. Darin sind alle Sensoren und Aktoren, zusammen als Busgeräte bezeichnet, im Gebäude mit der Fähigkeit ausgestattet, untereinander Informationen auszutauschen. Jedes Busgerät kann mit jedem anderen kommunizieren.

Die Verbraucher, also beispielsweise die Lampen, Antriebe, Haushaltsgeräte etc., werden in einem busgesteuerten Gebäudeautomatisierungssystem üblicherweise über Sensoren und Aktoren gesteuert. Ein Taster oder ein Lichtschalter ist ein Beispiel für einen Sensor. Eine Glühlampe oder eine LED-Leuchte ist beispielsweise an einem Schaltausgang eines Aktors angeschlossen. Ein Sensor in dem busbasierten Gebäudeautomatisierungssystem, also ein Taster beispielsweise, sendet über den Bus ein Telegramm, zum Beispiel einen Schaltbefehl für einen bestimmten Aktor, an alle angeschlossenen Busgeräte. Der angesprochene Aktor erkennt anhand des Telegramms, dass der Schaltbefehl für ihn ist und führt die Schalthandlung entsprechend des Schaltbefehls aus.

Die erfindungsgemäß vorgesehene Verbrauchsermittlungseinrichtung kann ein Stromzähler oder ein Netzanalysegerät sein. Ein Stromzähler erfasst in an sich bekannter Weise Strom und Spannung und bildet daraus eine Information über die momentane Leistungsaufnahme der dem Zähler zugeordneten Stromkreise, und unter Verwendung einer Integrationseinrichtung ermittelt er eine Information über den Energieverbrauch in den dem Zähler zugeordneten Stromkreisen. Insbesondere kann der Zähler ein sogenannter "intelligenter" Zähler sein, auch unter dem Begriff "smart meter" bekannt, der dem jeweiligen Anschlussnutzer den tatsächlichen Energieverbrauch und die tatsächliche Nutzungszeit anzeigt, und der Kommunikationsschnittstellen aufweist, die eine Fernabfrage erlauben.

Ein solcher Zähler, eine solche Verbrauchsermittlungseinrichtung, kann in vorteilhafter Weise als Informationen auf den Bus gebender Sensor ein Busgerät, somit ein Teil des busbasierten Gebäudeautomatisierungssystems sein.

Die erfindungsgemäße Lösung des der Erfindung zugrundeliegenden Problems beruht darauf, dass Messwerte von dem Zähler mit Informationen aus dem Gebäudeautomatisierungssystem derart verknüpft werden, dass durch die zeitliche Abhängigkeit von Verbrauchern und Steuerbefehlen in Verbindung mit Konfigurationsinformationen aus dem Gebäudeautomatisierungssystem die Leistung, die Art oder die Eigenschaften des Einzelverbrauchers ermittelt werden.

Dabei erfolgt erfindungsgemäß eine Verknüpfung von Informationen über den zeitlichen Verlauf des Stromverbrauchs in dem Stromnetz mit Informationen aus Schaltbefehlen, die dem einzelnen Verbraucher zugeordnet sind, in folgender weise. Wenn von einem Sensor ein Schaltbefehl für einen Aktor gesendet wird, dieser Aktor daraufhin den ihm zugeordneten Verbraucher einschaltet, so erhöht sich der Stromverbrauch, der von dem Zähler erfasst wird, insgesamt um denjenigen Wert, der der Leistungsaufnahme des gerade zugeschalteten Verbrauchers entspricht. Anhand der Daten in dem des Telegramm des Schaltbefehls ist in dem busbasierten Gebäudeautomatisierungssystem aus der Konfiguration des Systems her bekannt, um welchen Aktor, welchen Verbraucher, in welchem Gebäudeteil es sich handelt.

Das Gebäudeautomatisierungssystem ist also erfindungsgemäß eingerichtet, um Informationen über eine Änderung des gesamten Stromverbrauchs in dem Stromnetz als Reaktion auf das Senden eines Schaltbefehls an einen Aktor mit Informationen aus dem gesendeten Schaltbefehl zu verknüpfen, um daraus Informationen über die Art des dem Aktor zugeordneten Verbrauchers, den Ort des Verbrauchers und den Stromverbrauch des Verbrauchers zu erlangen.

Somit kann das busbasierte Gebäudeautomatisierungssystem die momentane Leistungsaufnahme dieses einzelnen Verbrauchers ermitteln, obwohl der Stromzähler nur den gesamten Stromverbrauch anzeigt.

Zusammen mit ebenfalls im Gebäudeautomatisierungssystem vorhandenen Informationen, wann der Verbraucher wieder ausgeschaltet wurde, kann die gesamte Einschaltdauer und damit der Energieverbrauch des Verbrauchers ermittelt werden. Das Gebäudeautomatisierungssystem ist also erfindungsgemäß eingerichtet, um aus Informationen von an den Aktor gesendeten Schaltbefehlen Informationen über die Einschaltdauer des Verbrauchers abzuleiten und diese mit den Informationen über den Stromverbrauch des Verbrauchers zur Ermittlung des Energieverbrauchs des Verbrauchers zu verknüpfen.

Neben dem busbasierten Gebäudeautomatisierungssystem ist keine weitere Installation von Geräten notwendig. Das erfindungsgemäße System zur Einzellasterkennung erfordert somit keinen erhöhten Installationsaufwand, es nutzt die Möglichkeiten eines busbasierten Gebäudeautomatisierungssystems.

Gemäß der Erfindung hat das Gebäudeautomatisierungssystem eine Analysevorrichtung zum Verknüpfen der Informationen über den zeitlichen Verlauf des Stromverbrauchs in dem Stromnetz mit Informationen aus Schaltbefehlen, die dem einzelnen Verbraucher zugeordnet sind, um daraus die Informationen über den Energieverbrauch des einzelnen Verbrauchers zu erlangen.

Die Analysevorrichtung kann in vorteilhafter weise als Funktionsbaugruppe innerhalb eines Sensors oder eines Aktors des Gebäudeautomatisierungssystems ausgebildet sein. In vorteilhafter Weise ist sie dabei als Softwaremodul ausgeführt. Jedes Busgerät eines busbasierten Gebäudeautomatisierungssystems hat nämlich wenigstens einen Mikroprozessor mit Arbeitsspeicher, in dem ein - nach entsprechender Konfigurierung - ausführbares Anwendungsprogramm für den Betrieb des Busgerätes gespeichert ist. Die Analysevorrichtung kann ein Softwaremodul in diesem Anwendungsprogramm sein. Die Konfigurierung eines Gebäudeautomatisierungssystems wie beispielsweise eines KNX-Bus-orientierten Gebäudeautomatisierungssystems, ist im Prinzip bekannt.

Die Analysevorrichtung kann dabei in vorteilhafter Weise als Funktionsbaugruppe innerhalb der Verbrauchsermittlungseinrichtung ausgebildet sein Die Analysevorrichtung kann auch ein selbständiges Busgerät in dem Gebäudeautomatisierungssystem sein.

Die Analysevorrichtung kann auch eingerichtet sein, um die Informationen über den Energieverbrauch des einzelnen Verbrauchers mit Konfigurationsdaten des Gebäudeautomatisierungssystems zu verknüpfen. Solche Konfigurationsdaten beziehen sich beispielsweise auf die Bezeichnung des Verbrauchers (beispielsweise als Leuchte, Lüfter, oder ähnliches), auf das Gewerk, in dem der Verbraucher sich befindet (beispielsweise in der Beleuchtung, in der Heizung oder ähnliches), oder auf den Installationsort (beispielsweise den spezifischen Gebäudeteil oder den genauen Raum oder ähnliches).

Die Analysevorrichtung kann auch eingerichtet sein, um die Informationen über den Energieverbrauch des einzelnen Verbrauchers an ein übergeordnetes Informationsverarbeitendes System weiter zu geben, beispielsweise an ein Demand-Side-Managementsystem, ein Energiemanagementsystem oder ein Smart Grid.

Die Erfindung sowie weitere Ausführungsmöglichkeiten und Vorteile der Erfindung soll jetzt anhand der Figuren weiter erläutert werden.

Es zeigen:
- Fig. 1: einen Schaltaktor mit vier angeschlossenen Leuchten, die an ein Stromnetz in einem Gebäude angeschlossen sind, mit einem Stromzähler, gemäß dem Stand der Technik,
- Fig. 2: einen Schaltaktor mit vier angeschlossenen Leuchten, die mit jeweils einem eigenen Zähler an ein Stromnetz in einem Gebäude angeschlossen sind, gemäß dem Stand der Technik,
- Fig. 3: schematisch ein erfindungsgemäßes System zur Ermittlung des Energieverbrauchs eines einzelnen Verbrauchers, der an ein Stromnetz in einem Gebäude angeschlossen ist.

Es werden zunächst die Figuren 1 und 2 betrachtet, die den Stand der Technik schematisch darstellen.

In der Figur 1 ist schematisch ein dreiphasiges Stromnetz 1 dargestellt, mit den drei Phasenleitern L1, L2, L3 und einem Neutralleiter N. Der Stromverbrauch in diesem Stromnetz 1 wird gesamthaft mit einem Stromzähler 2 erfasst. An das Stromnetz 1 sind vier Verbraucher 3, 4, 5, 6 angeschlossen. Hier in der vereinfachten Schemadarstellung sind es Leuchten, die jeweils zwischen einem Phasenleiter und dem Neutralleiter geschaltet sind. So ist der erste Verbraucher 3 zwischen der Phasenleitung L1 und dem Neutralleiter N geschaltet, der zweite Verbraucher 4 ist an den Phasenleiter L2 angeschlossen, der dritte Verbraucher 5 ist 'wieder an den Phasenleiter L1 angeschlossen, und der vierte Verbraucher 6 ist an den Phasenleiter L2 angeschlossen.

Das Ein- und Ausschalten jedes der vier Verbraucher erfolgt mittels eines Schaltaktors 7. Der Schaltaktor 7 ist ein Busgerät in einem busbasierten Gebäudeautomatisierungssystem. Hier ist es ein Gebäudeautomatisierungssystem mit einem Gebäudebus nach dem KNX-Standard, kurz KNX-System. Die KNX-Busleitung, hier eine Zweidrahtleitung nach dem KNX-TP Standard - TP steht für Twisted Pair - ist mit der Bezugsziffer 8 bezeichnet. Der Schaltaktor 7 könnte alternativ auch als ein Busgerät in einem KNX-PL - PL steht für Power Line, hierbei wird das vorhandene Starkstromnetz für die Datenübertragung genutzt - ausgebildet sein. Es könnte aber prinzipiell auch ein Busgerät in einem Gebäudeautomatisierungssystem sein, das einen andere Bustechnologie verwendet, etwa zum Beispiel Ethernet, CAN-Bus, Smart-BUS, etc.

Der Schaltaktor 7 hat vier Schaltstellen 9, 10, 11, 12. An jede der Schaltstellen 9 - 12 ist über jeweils einen Schaltausgang einer der Verbraucher 3 - 6 angeschlossen, jede der Schaltstellen 9 - 12 ist einem der Verbraucher 3 - 6 zugeordnet.

Schematisch dargestellt in der Figur 1 auch ein Sensor 13, ebenfalls ein KNX - Busgerät, beispielsweise ein Taster. Um einen der Verbraucher 3 - 6, also beispielsweise den Verbraucher 3, ein- oder auszuschalten, sendet ein Sensor im System, also beispielsweise der Taster 13, nach entsprechender Betätigung ein Telegramm, das einen entsprechenden Schaltbefehl enthält, auf den Bus 8. Das Telegramm enthält eine Gruppenadresse, im KNX-System beispielsweise dargestellt in der Form 2/0/1 mit Haupt-, Mittel- und Untergruppe. Anhand der Gruppenadresse stellt ein empfangendes Gerät, also hier der Aktor 7, fest, ob das Telegramm für es relevant ist. Stellt der Aktor 7 dies fest, so führt er den Schaltbefehl aus. War der Schaltbefehl ein Einschaltbefehl, so schließt der Schaltaktor 7 als Ergebnis die Kontakte an der Schaltstelle 9 und Strom fließt aus dem Stromnetz 1 durch den Verbraucher 3. Bei einem Ausschaltbefehl wird entsprechend an der Schaltstelle 9 der Kontakt geöffnet und der Stromfluss durch den Verbraucher 3 unterbrochen.

In der Figur 2 ist das System nach Figur 1 dadurch ergänzt, dass zur individuellen Verbrauchserfassung an jedem der Verbraucher 3 - 6 jeweils zu jedem der Verbraucher 3 - 6 ein eigener Stromzähler 14, 15, 16, 17 in Reihe geschaltet ist. Der Gesamtzähler 2 aus Figur 1 entfällt hier.

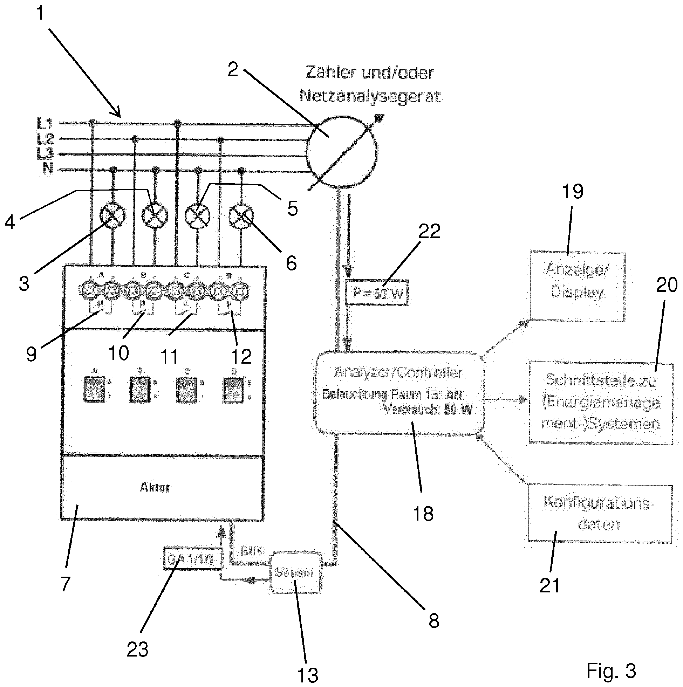

Es werde nun die Figur 3 betrachtet. Diese zeigt schematisch ein erfindungsgemäßes System zur Ermittlung des Energieverbrauchs eines einzelnen Verbrauchers, hier beispielsweise des Verbrauchers 3. Das aus dem Stand der Technik bekannte System nach Figur 1 ist dabei erfindungsgemäß ergänzt um eine Analysevorrichtung 18. Diese ist hier als ein eigenständiges Busgerät in dem KNX-basierten Gebäudeautomatisierungssystem ausgeführt.

Die Analysevorrichtung 18 könnte alternativ auch als Funktionsbaugruppe innerhalb eines bereits vorhandenen Busgerätes, zum Beispiel eines Sensors, etwa des Sensors 13, oder als Funktionsbaugruppe innerhalb des Zählers 2 ausgebildet sein. In diesem Fall ist die Analysevorrichtung 18 dann als Softwaremodul in dem Anwendungsprogramm des jeweiligen Busgerätes ausgeführt.

In dem erfindungsgemäßen System nach Figur 3 ist der Zähler 2 ebenfalls als ein Busgerät ausgeführt, er hat hier bezogen auf den KNX-Bus die Funktionalität eines Sensors.

Die Analysevorrichtung 18 erhält über den KNX-Bus 8 Informationen 22 über den zeitlichen Verlauf des Gesamtstromverbrauchs, wie er von dem Zähler 2 erfasst wird, und Informationen 23 aus den Schaltbefehlen an den Aktor 7. Die Ermittlung des Energieverbrauchs des einzelnen Verbrauchers 3 erfolgt dann in folgender Weise.

In dem KNX-System wird von dem Sensor 13 ein Schaltbefehl mit der Gruppenadresse 1/1/1 für den Schaltaktor 7 auf den Bus 8 gegeben. Der Schaltaktor 7 führt den Schaltbefehl aus, die Schaltstelle 9 wird geschlossen, und der Verbraucher 3, der an dem der Schaltstelle 9 zugeordneten Schaltausgang angeschlossen ist, wird eingeschaltet.

Aufgrund des zusätzlichen Stromverbrauchs des Verbrauchers 3 nach dem Einschalten misst der Zähler 2 nach dem Einschalten einen lastanstieg von, in diesem Beispiel, etwa 50W. Dieser Lastanstieg kann nun in der Analysevorrichtung 18 mit der Gruppenadresse verknüpft werden. Die Gruppenadresse enthält Informationen zum Kommunikationsobjekt, zum Datenpunkttyp sowie Informationen zur Art bzw. Anwendung des Verbrauchers, ob es sich beispielsweise um eine Deckenleuchte handelt. Weiter enthält die Gruppenadresse Informationen, in welchem Gebäudeteil geschaltet werden soll, beispielsweise in welchem Raum, z.B. Raum 13, und zu welchem Gewerk der Verbraucher gehört, beispielsweise zum Gewerk "Beleuchtung".

Nachdem die Informationen in der Analysevorrichtung 18 verknüpft sind, steht im KNX-basierten Gebäudeautomatisierungssystem folgende Information zur Verfügung: "Beleuchtung in Raum 13 an, Momentanverbrauch 50W". Wenn zusätzlich im Gebäudeautomatisierungssystem die Einschaltdauer des Verbrauchers 3 mitprotokolliert wird, so kann damit der Energieverbrauch in kWh ermittelt und dem System für die weitere Verarbeitung beziehungsweise Anzeige zur Verfügung gestellt werden.

Zur erfindungsgemäßen Ermittlung der Einzellast eines Verbrauchers kann die erfindungsgemäße Analysevorrichtung 18 in ein oder mehrere beliebige Geräte, welche eine Kommunikationsverbindung zum Gebäudeautomatisierungssystem haben, integriert werden. Insbesondere kann die Integration in einen Zähler oder in ein separates Analysegerät erfolgen. Die Integration in einen Zähler oder in ein Analysegerät hat den Vorteil, dass die Last- beziehungsweise die Messinformationen nicht über das Gebäudeautomatisierungssystem, nicht über den Gebäudeautomatisierungsbus, übertragen werden müssen.

Die Analysevorrichtung 18 ist mit einer Schnittstelle 20 zu einem übergeordneten Informationsverarbeitenden System gekoppelt, beispielsweise zu einem Energiemanagementsystem, einem Demand-Side-management-System oder einem "Smart Grid". Die Schnittstelle 20 ist in der Figur 3 funktional als von der Analysevorrichtung 18 separiert dargestellt, sie kann tatsächlich aber als Funktionsmodul innerhalb eines eigenen Busgerätes, das die Analysevorrichtung 18 darstellt, integriert sein, oder als weiteres Funktionsmodul in demjenigen Busgerät, sei es Sensor oder Aktor, in dem bereits das die Analysevorrichtung realisierende Funktionsmodul integriert ist.

Die Analysevorrichtung 18 ist eingerichtet, um die Informationen über den Energieverbrauch des einzelnen Verbrauchers mit Konfigurationsdaten des Gebäudeautomatisierungssystems zu verknüpfen. Konfigurationsdaten umfassen Informationsdaten des Verbrauchers bezüglich seines Namens, z.B. Leuchte, Lüfter, etc., des Gewerkes, dessen teil er ist, z.B. Beleuchtung, Heizung, und seines Installationsortes, z.B. dem Gebäudeteil oder der Raumnummer. Dazu ist eine Schnittstelle 21 zu einem Konfigurationsdaten-Speicher vorhanden Die Schnittstelle 21 ist in der Figur 3 funktional als von der Analysevorrichtung 18 separiert dargestellt, sie kann tatsächlich aber als Funktionsmodul innerhalb eines eigenen Busgerätes, das die Analysevorrichtung 18 darstellt, integriert sein, oder als weiteres Funktionsmodul in demjenigen Busgerät, sei es Sensor oder Aktor, in dem bereits das die Analysevorrichtung realisierende Funktionsmodul integriert ist..

Die Analysevorrichtung 18 ist auch mit einer Anzeige 19, einem Display, gekoppelt, um den momentanen leistungsverbrauch und gegebenenfalls weitere Informationen anzuzeigen. Die Anzeige 19 ist in der Figur 3 funktional als von der Analysevorrichtung 18 separiert dargestellt, sie kann tatsächlich aber als Funktionsmodul innerhalb eines eigenen Busgerätes, das die Analysevorrichtung 18 darstellt, integriert sein, oder als weiteres Funktionsmodul in demjenigen Busgerät, sei es Sensor oder Aktor, in dem bereits das die Analysevorrichtung realisierende Funktionsmodul integriert ist.

Zusammenfassend ermöglicht das erfindungsgemäße System die Durchführung eines Verfahrens zur Erkennung der Leistung und der Zuordnung des Energieverbrauchs zu einer Einzellast, die zusammen mit anderen Lasten an ein Stromnetz in einem Gebäude angeschlossen ist.

Ein elektrischer Verbraucher kann eine mehr oder weniger konstante Leistung aufnehmen. Für den Fall, dass die Leistung konstant ist, kann der Energieverbrauch durch Multiplikation von Leistung P und der Einschaltdauer t errechnet und dem einzelnen Verbraucher zugeordnet werden.

Auch wenn der Verbraucher ein zwar zeitlich variables, aber dennoch vorhersehbares zeitliches Verbrauchsprofil hat, wie es zum Beispiel bei einer Glühlampe mit einer relativ hohen Einschaltleistung und konstanter, niedrigerer Dauerleistung ist, ist eine in vielen Fällen ausreichende Genauigkeit bei der Ermittlung des Energieverbrauchs möglich und kann somit der Einzellast zugeordnet werden.

Da der zeitliche Verlauf des Stromverbrauchs aufgenommen wird, kann anhand dieses zeitlichen Verbrauchsprofils erkannt werden, um welche Lastart es sich handeln könnte, etwa um eine Glühlampe (hohe Einschaltleistung, niedrigere konstante Dauerleistung) oder um einen Kühlschrank (regelmäßige, gleich hohe Schaltpulse)

Mit Hilfe des erfindungsgemäßen Systems kann man Eigenschaften und Zustände des Betriebsmittels beziehungsweise des Verbrauchers erkennen, etwa ob er ein- oder ausgeschaltet ist, wie viele Schalthandlungen in einer bestimmten Zeit vorgenommen wurden, wie hoch die aufsummierte Leistungsaufnahme war, ob es Anomalien im Verlauf der aufgenommen Leistung gab und so weiter. Solche Informationen, die mit dem erfindungsgemäßen System mit anfallen und mit erfasst werden, können zu Diagnose- und Wartungszwecken ausgewertet werden. Man kann dann etwa einen defekt, einen drohenden Ausfall oder den Verschleißzustand des Verbrauchers oder des Betriebsmittels frühzeitig erkennen und im Sinne einer bedarfsgesteuerten Wartung rechtzeitige und proaktiv mit angemessenen Wartungsmaßnahmen reagieren.

Man erhält Echtzeit-Verbrauchsinformationen einzelner Lasten oder Lastkreise, und man kann damit Lastoptimierungen durchführen.

Man hat einen geringen Installationsaufwand, da ein busbasiertes Gebäudeautomatisierungssystem ohne zusätzlichen Installationsaufwand erweiterbar ist.

Insbesondere sind zur Einzellasterfassung keine Unter- oder Zwischenzähler erforderlich.

### Bezugszeichenliste

- 1: Stromnetz
- 2: Stromzähler
- 3: Verbraucher
- 4: Verbraucher
- 5: Verbraucher
- 6: Verbraucher
- 7: Schaltaktor
- 8: Busleitung
- 9: Schaltstelle
- 10: Schaltstelle
- 11: Schaltstelle
- 12: Schaltstelle
- 13: Sensor
- 14: Zähler
- 15: Zähler
- 16: Zähler
- 17: Zähler
- 18: Analysevorrichtung
- 19: Anzeige
- 20: Schnittstelle zu einem übergeordneten Informationssystem
- 21: Konfigurationsdaten-Speicher
- 22: Informationen über den zeitlichen Verlauf des Stromverbrauchs
- 23: Informationen aus dem Schaltbefehl

## Patentansprüche

1. System zur Ermittlung des Energieverbrauchs eines einzelnen Verbrauchers (3), der an ein Stromnetz (1) in einem Gebäude angeschlossen ist, wobei das System ein busbasiertes Gebäudeautomatisierungssystem umfasst, mit Informationen auf den Bus (8) gebenden und/oder Schaltbefehle sendenden Sensoren (13) und Schaltbefehle empfangenden Aktoren (7) zum Steuern und/oder Schalten des Verbrauchers (3), und mit einer Verbrauchsermittlungseinrichtung (2) zum Ermitteln von Informationen über den Stromverbrauch in dem Stromnetz (1),
wobei das Gebäudeautomatisierungssystem eingerichtet ist, um Informationen über den zeitlichen Verlauf des Stromverbrauchs in dem Stromnetz (1) mit Informationen aus Schaltbefehlen, die dem einzelnen Verbraucher (3) zugeordnet sind, zu verknüpfen, um daraus Informationen über den Energieverbrauch des einzelnen Verbrauchers (3) zu erlangen und in das Gebäudeautomatisierungssystem eine Analysevorrichtung integriert ist,
**dadurch gekennzeichnet,**
**dass** die Analysevorrichtung dazu eingerichtet ist, die informationen über eine Änderung des gesamten Stromverbrauchs in dem Stromnetz (1) als Reaktion auf das Senden eines Schaltbefehls an einen Aktor (7) mit Informationen aus dem gesendeten Schaltbefehl zu verknüpfen, um daraus Informationen über die Art des dem Aktor (7) zugeordneten Verbrauchers (3), den Ort des Verbrauchers (3) und den Stromverbrauch des Verbrauchers (3) zu erlangen, sowie aus Informationen von an den Aktor (3) gesendeten Schaltbefehlen Informationen über die Einschaltdauer des Verbrauchers (3) abzuleiten und diese mit den Informationen über den Stromverbrauch des Verbrauchers (3) zur Ermittlung des Energieverbrauchs des Verbrauchers (3) zu verknüpfen.

2. System nach Anspruch 1, **dadurch gekennzeichnet, dass** die Verbrauchsermittlungseinrichtung (2) ein Stromzähler oder ein Netzanalysegerät ist, und dass die Verbrauchsermittlungseinrichtung (2) als Informationen auf den Bus gebender Sensor ein Teil des busbasierten Gebäudeautomatisierungssystems ist.

3. System nach Anspruch 1 oder 2, **dadurch gekennzeichnet, dass** die Analysevorrichtung (18) ein selbständiges Busgerät in dem Gebäudeautomatisierungssystem ist.

4. System nach Anspruch 1 oder 2, **dadurch gekennzeichnet, dass** die Analysevorrichtung (18) als Funktionsbaugruppe innerhalb eines Sensors oder eines Aktors des Gebäudeautomatisierungssystems ausgebildet ist.

5. System nach Anspruch 1 oder 2, **dadurch gekennzeichnet, dass** die Analysevorrichtung (18) als Funktionsbaugruppe innerhalb der Verbrauchsermittlungseinrichtung ausgebildet ist.

6. System nach einem der vorstehenden Ansprüche, **dadurch gekennzeichnet, dass** die Analysevorrichtung (18) eingerichtet ist, um die Informationen über den Energieverbrauch des einzelnen Verbrauchers (3) mit Konfigurationsdaten (21) des Gebäudeautomatisierungssystems zu verknüpfen.

7. System nach einem der vorstehenden Ansprüche, **dadurch gekennzeichnet, dass** die Analysevorrichtung (18) eingerichtet ist, um die Informationen über den Energieverbrauch des einzelnen Verbrauchers an ein übergeordnetes Informationsverarbeitendes System (20) weiter zu geben.

## Claims

1. System for ascertaining the energy consumption of an individual load (3) that is connected to a power supply system (1) in a building, wherein the system comprises a bus-based building automation system, having sensors (13) outputting information to the bus (8) and/or transmitting switching commands and actuators (7) receiving switching commands in order to control and/or switch the load (3), and having a consumption ascertainment device (2) for ascertaining information regarding the power consumption in the power supply system (1), wherein the building automation system is configured to combine information regarding the time characteristic of the power consumption in the power supply system (1) with information from switching commands associated with the individual load (3) in order to obtain therefrom information regarding the energy consumption of the individual load (3) and an analysis apparatus is integrated in the building automation system, **characterized in that** the analysis apparatus is configured so as, in response to a switching command being transmitted to an actuator (7), to combine the information regarding a change in the overall power consumption in the power supply system (1) with information from the transmitted switching command in order to obtain therefrom information regarding the type of load (3) associated with the actuator (7), the location of the load (3) and the power consumption of the load (3), and to derive information regarding the switched-on period of the load (3) from information from switching commands transmitted to the actuator (3), and to combine said information with the information regarding the power consumption of the load (3) in order to ascertain the energy consumption of the load (3).

2. System according to Claim 1, **characterized in that** the consumption ascertainment device (2) is an electricity meter or a supply system analysis unit, and **in that** the consumption ascertainment device (2), as a sensor outputting information to the bus, is part of the bus-based building automation system.

3. System according to Claim 1 or 2, **characterized in that** the analysis apparatus (18) is an independent bus unit in the building automation system.

4. System according to Claim 1 or 2, **characterized in that** the analysis apparatus (18) is designed as a functional assembly within a sensor or an actuator of the building automation system.

5. System according to Claim 1 or 2, **characterized in that** the analysis apparatus (18) is designed as a functional assembly within the consumption ascertainment device.

6. System according to one of the preceding claims, **characterized in that** the analysis apparatus (18) is configured to combine the information regarding the energy consumption of the individual load (3) with configuration data (21) of the building automation system.

7. System according to one of the preceding claims, **characterized in that** the analysis apparatus (18) is configured to forward the information regarding the energy consumption of the individual load to a superordinate information-processing system (20).

## Revendications

1. Système de détermination de la consommation d'énergie d'un consommateur individuel (3) qui est raccordé à un réseau électrique (1) situé dans un bâtiment, le système comprenant un système d'automatisation de bâtiment basé sur un bus, le système comportant des capteurs (13) qui délivrent des informations sur le bus (8) et/ou qui envoient des instructions de commutation et des actionneurs (7) qui reçoivent des instructions de commutation et qui sont destinés à commander et/ou commuter le consommateur (3), et un moyen de détermination de consommation (2) destiné à déterminer des informations sur la consommation électrique dans le réseau électrique (1), le système d'automatisation de bâtiment étant conçu pour combiner des informations sur l'évolution de la consommation d'électricité dans le réseau électrique (1) à des informations provenant d'instructions de commutation qui sont associées au consommateur individuel (3) afin d'obtenir des informations sur la consommation d'énergie du consommateur individuel (3) et un dispositif d'analyse étant intégré dans le système d'automatisation de bâtiment,
**caractérisé en ce que**
le dispositif d'analyse est conçu pour combiner les informations sur une variation de la consommation électrique totale dans le réseau électrique (1), en réaction à l'envoi d'une instruction de commutation à un actionneur (7), à des informations provenant de l'instruction de commutation envoyée afin d'obtenir des informations sur le type de consommateur (3) associé à l'actionneur (7), l'emplacement du consommateur (3) et la consommation électrique du consommateur (3), ainsi que pour déduire des informations sur la durée d'activation du consommateur (3) à partir d'informations provenant des instructions de commutation envoyées à l'actionneur (3) et pour combiner ces informations aux informations sur la consommation électrique du consommateur (3) afin de déterminer la consommation d'énergie du consommateur (3) .

2. Système selon la revendication 1, **caractérisé en ce que** le moyen de détermination de consommation (2) est un compteur de courant ou un analyseur de réseau, et **en ce que**, en tant que capteur délivrant des informations sur le bus, le moyen de détermination de consommation (2) est une partie du système d'automatisation de bâtiment basé sur un bus.

3. Système selon la revendication 1 ou 2, **caractérisé en ce que** le dispositif d'analyse (18) est une unité de bus indépendante dans le système d'automatisation de bâtiment.

4. Système selon la revendication 1 ou 2, **caractérisé en ce que** le dispositif d'analyse (18) est conçu comme un ensemble fonctionnel à l'intérieur d'un capteur ou d'un actionneur du système d'automatisation de bâtiment.

5. Système selon la revendication 1 ou 2, **caractérisé en ce que** le dispositif d'analyse (18) est conçu comme un ensemble fonctionnel à l'intérieur du moyen de détermination de consommation.

6. Système selon l'une des revendications précédentes, **caractérisé en ce que** le dispositif d'analyse (18) est conçu pour combiner les informations sur la consommation d'énergie du consommateur individuel (3) à des données de configuration (21) du système d'automatisation de bâtiment.

7. Système selon l'une des revendications précédentes, **caractérisé en ce que** le dispositif d'analyse (18) est conçu pour délivrer les informations sur la consommation d'énergie du consommateur individuel à un système de traitement d'informations de niveau supérieur (20).
